# EUROPEAN PATENT APPLICATION

(11) **EP 1 220 300 A2**
(43) Date of publication of application: **03.07.2002**
(21) Application number: 01129994.8
(22) Date of filing: 17.12.2001
(51) Int. Cl.: H01L 21/00

(54) **Light irradiation part arrangement of a heating device**

(30) Priority: 27.12.2000 JP 2000397555
(71) Applicant: USHIODENKI KABUSHIKI KAISHA, Chiyoda-ku, Tokyo 100-0004 (JP)
(72) Inventor: Suzuki, Shinji, Yokohama-shi, Kanagawa-ken (JP)
(74) Representative: Tomerius, Isabel, Dr. Dipl.-Chem.

(57) **Abstract**

A light irradiation part arrangement of a heating device of the light irradiation type having plurality of lamps in a light irradiation chamber. The light irradiation part arrangement includes a mirror behind the emitting tube portions of the lamps which reflects the light from the emitting tube portions, a plate located above the mirror, and a duct located between the mirror and the plate adapted to supply cooling air to the plurality of lamps, the duct defining a hollow area between the minor and the plate that is positioned to allow routing of the at least one insertion portion. The duct is connected to at least one cooling air inlet opening that lets in cooling air, and has at least one cooling air exhaust opening that blows cooling air out of the duct toward the light irradiation chamber.

## Description

### Background of the invention

### Field of the invention

The invention relates to the arrangement of the light irradiation part of a heating device of the light irradiation type, in which a semiconductor wafer for layer formation, diffusion, baking or for similar purposes is subjected to rapid heating, holding at a high temperature, and rapid cooling. The invention specifically relates to the arrangement of the part in which cooling air flows to cool the lamp, and a heating device of the light irradiation type with this arrangement.

### Description of the Related Art

Heat treatment using light irradiation is widely used in the production of semiconductors such as layer formation, diffusion, baking or the like. The cooling arrangement for cooling the respective part of the lamp in a heating device of the light irradiation type to a suitable temperature is discussed in the Japanese patent disclosure document 2000-114196 that was proposed by the applicant. It is noted that this Japanese patent disclosure document 2000-114196 is not applicable prior art with respect to the present invention as described below but is merely discussed herein to provide information on recent developments in this area of technology. This document shows an arrangement in a device using annular lamps in which the cooling air in tube portions of the lamps, and the cooling air in sealing areas of the lamp, are evacuated via an air box.

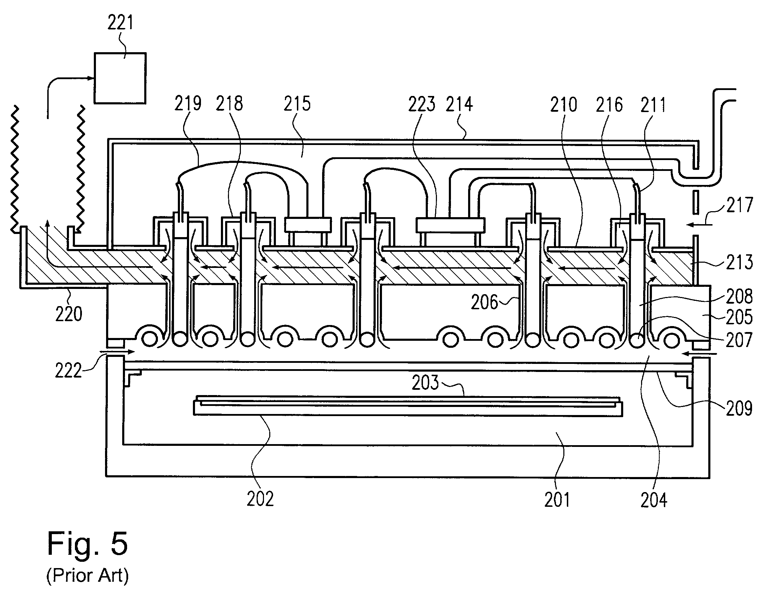

Figure 5 shows the cooling arrangement described in the above document. In the figure, a semiconductor wafer 203 (hereinafter "wafer") which is exposed to thermal irradiation is placed on a wafer holding frame 202 within a light irradiation chamber 201 which is divided by a quartz window 209. In a lighting part for heating of this wafer 203, there are several annular lamps 204 which emit light containing infrared rays, each with different diameters and arranged concentrically to one another. Reference number 205 is a metallic mirror of aluminum or the like with a surface which is plated with a material such as gold, for example, which reflects infrared rays with high efficiency, and is provided with concentric grooves and openings 206 through which insertion portions 208 of the lamps 204 pass. The shape of the lamps 204 is such that the lamps 204 lie in these grooves. Since the mirror 205 reaches a high temperature due to the light from the lamps 204 according to the material of the mirror 205 and the thermal resistance temperature of the plating of the surface, there is a cooling arrangement like a water cooling system or the like.

In the above described heating device of the light irradiation type, heat treatment of the wafer 203 is done by heating the wafer to 800°C to 1200°C. Therefore, in addition to cooling of the above described mirror 205, the respective part of the lamp 204, such as the emitting tube part 207, the insertion portion 208, the sealing area 211 and the like, must also be cooled to a suitable temperature. Therefore the cooling arrangement described below is undertaken.

The back of the mirror 205 is divided by a plate 210 through which an air box 213 for the passage of the cooling air is arranged. The back of the plate 210 is divided by a cover 214, yielding a cover chamber 215 which is provided with an inlet opening 217 for cooling air which cools the sealing areas 211. The plate 210 underneath the cover chamber 215 is provided with openings 216 through which the respective sealing area 211 and one part of the insertion portion 208 of the lamp 204 passes. The insertion portions 208 of the lamps 204 penetrate the mirror 205 and the air box 213. The sealing areas 211 extend as far as the cover chamber 215. The plate 210 of the cover chamber 215 is provided with lamp holding components 218 which hold the insertion portions 208 of the lamps securely and attaches the lamps 204. The plate 210 is also provided with clamp devices 223 which connect the lines 219 of the lamps 204 to the line system from the lamp power source, and the like.

The air box 213 is a cavity between the upper part of the mirror 205 and the plate 210. An outlet channel 220 which is connected to an exhauster 221 is connected to one side of the air box 213. The light irradiation chamber 201 is provided with an inlet opening 222 for cooling air which is used to cool the lamps 204.

In luminous operation of the lamps 204, the above described exhauster 221 is operated so that air is blown out of the air box 213. In this way, the air from the outside is let in as cooling air through the inlet opening 222 for cooling air of the light irradiation chamber 201. As shown using the arrows in Figure 5, the cooling air is deflected along the surfaces of the lamps 204 into the gaps between the lamps 204, and the mirror 205. In this way, the cooling air cools the lamps 204, passes though the openings 206 into which insertion portions 208 are inserted through the mirror 205, and enters the air box 213. The cooling air which has entered the air box 213 is withdrawn through the exhauster 221, passes from the air box 213 through the outlet channel 220, and is evacuated.

In the heating device of the light irradiation type in Figure 5, the cooling air reaches 100°C to 150°C after being used for lamp cooling. The temperature of the surface of the exterior of the air box 213 is accordingly high. The device shown in Figure 5 has a stepped arrangement in which, proceeding from one side of the light irradiation chamber, there are the mirror 205, the air box 213 and the cover chamber 215. The exterior of the air box 213 is used directly as the exterior of the device. Therefore, the surface of the part which corresponds to the air box 213 (i.e. the crosshatched area in Figure 5) reaches a high temperature over the entire periphery of the device.

Both for devices in the production of semiconductors and also for various other devices, there are strict safety criteria for different companies in various countries. At a surface temperature of, for example, higher than 60°C, there must be several protective gratings and covers to prevent the operator who is actuating the devices from coming into direct contact with heated parts. Therefore, in a device with a plurality of areas with a high temperature, many protective gratings and covers are needed which causes the device to become accordingly larger and costs become higher.

Recently, the diameter of the wafer has been growing. Accordingly, in a heating device of the light irradiation type, there is a demand for increasing the number of lamps and the energy emitted by the individual lamp. Therefore, a larger amount of cooling air is needed for cooling the lamps. If, for example, a wafer with a diameter from 200 mm to 300 mm is to be exposed to a reaction, cooling air from 10 m³/minute to 20 m³/minute is required in the heating device of the light irradiation type lamp.

A device for producing semiconductors is located in a clean room in which the temperature, the humidity and the amount of waste are strictly controlled. In operation of the device, the clean air used as the lamp cooling air in the above described manner is consumed in a large amount. This increases production costs. Therefore, in a semiconductor plant, it is desirable for the cooling device be a system with circulating cooling in which exhaust gas is cooled and re-used as cooling air. It is again noted that this Japanese patent disclosure document 2000-114196 is not applicable prior art with respect to the present invention.

For the system with circulating cooling, the device must have an arrangement in which intense aspiration and intense evacuation can be carried out. However, in the device shown in Figure 5, there is no intense aspiration, but cooling air is inlet from the vicinity of the light irradiation chamber. It is therefore not possible to operate the system with circulating cooling.

Pending U.S. patent application Ser. No. 09/749,896 entitled LAMP UNIT FOR LIGHT RADIATION TYPE HEATING AND PROCESSING DEVICE filed December 29, 2000 which is also assigned to the present assignees, is also noted for providing additional information on the recent developments in this area of technology. It is further noted that like the previously discussed Japanese patent disclosure, the '896 application is not applicable prior art with respect to the present invention.

### Summary of the Invention

The present invention was devised to eliminate the above described disadvantages. One object of the invention is to devise an arrangement of the light irradiation part of a heating device of the light irradiation type, and to devise a heating device of the light irradiation type which prevents the part of the exterior surface subject to a temperature increase from being located on the surface of the device as much as possible, the temperature increase taking place by passage of the cooling air which has a high temperature due to lamp cooling. Another object is to enable intense aspiration and intense evacuation.

These and other objects and advantages are achieved by the present invention in that the light irradiation part of a heating device of the light irradiation type includes a mirror, a toroidal duct, and a plate. The mirror is located behind the emitting tube portions of lamps located in the light irradiation chamber to reflect light from the emitting tube portions, and moreover, is provided with openings through which insertion portions and sealing areas of the lamps pass. The toroidal duct having a hollow area is located on the back of the mirror and supplies cooling air to the lamp. The plate is located on the duct and has openings through which sealing area of the lamps pass.

The above described duct lets in cooling air from the cooling air inlet opening. Between the light irradiation chamber and the duct, there is an opening from which cooling air is supplied to the lamps. The cooling air which cools the emitting tube portions of the lamps, passes through the openings of the above described mirror and is evacuated via the back of the mirror, the hollow area of the duct, and the space surrounding the plate from the evacuation opening located in the outlet channel.

In the above described arrangement, the duct for admitting the cooling air is located on the back of the mirror such that the outside periphery of the device is surrounded. The cooling air is supplied to the lamps via this duct. The temperature of the exterior surface of the duct is, therefore, at the same temperature of the admitted cooling air.

The cooling air which has cooled the lamps and which has reached a high temperature is collected in the hollow area of the duct which is surrounded by the back of the mirror and the plate, and is evacuated from the outlet channel.

Therefore, area of the surface of the device which reaches a high temperature relates only to the area of this outlet channel. If only this area reaches a high temperature, the device is not unduly enlarged and an increase in costs can be avoided even if, for example, there is a cover or the like.

Furthermore, since the cooling air is let in from the cooling air inlet opening located in the duct and is evacuated from the evacuation opening located in the outlet channel, a system with circulating cooling can be easily built in which exhaust gas is reused as the cooling air.

These and other advantages and features of the present invention will become more apparent from the following detailed description of the preferred embodiments of the present invention when viewed in conjunction with the accompanying drawings.

### Brief Description of the Drawings

Figure 1 shows an exploded schematic illustration of a light irradiation part of a heating device of the light irradiation type in accordance with one embodiment of the invention;

Figure 2(a) shows a schematic cross-sectional view along A-A of the flow of cooling air in the light irradiation part shown in Figure 1;

Figure 2(b) shows a schematic cross-sectional view along B-B of the flow of cooling air in the light irradiation part shown in Figure 1;

Figure 3 shows a schematic illustration of the installation of a system having circulating cooling into the light irradiation part shown in Figure 1 in which the evacuated cooling air is re-used;

Figure 4 shows an exploded schematic illustration of one embodiment of the light irradiation part in accordance with the present invention; and

Figure 5 shows a schematic illustration of a cooling arrangement.

### Detailed Description of the Preferred Embodiment

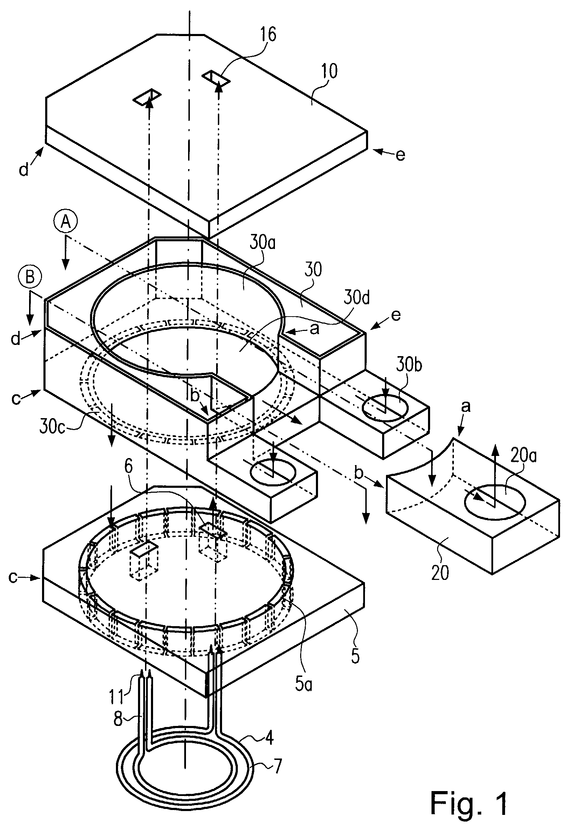

Figure 1 schematically shows one embodiment of an arrangement of the light irradiation part of a heating device of the light irradiation type in accordance with the present invention in a perspective exploded view. In installation, points a, b, c, d and e of the parts coincide with one another. In the figure, the parts corresponding to the arrangement of Figure 5 are provided with the similar reference numbers as in Figure 5 except that the numbers are under 100. The reference number 4 labels a lamp, reference number 5 labels a mirror, reference number 10 labels a plate and number 30 labels a duct which has a hollow area 30a between the mirror 5 and the plate 10 and which is toroidal in shape in the present embodiment. In Figure 1, fasteners, small mounting parts, and the like for mounting the respective part are not shown in order to make the main points of the arrangement more clear. In the upper area of the plate 10, terminal devices or the like are installed to supply electricity to the lamps 4 as in Figure 5. Furthermore, there is a cover (not shown in Figure 1) which forms a cover chamber in the same manner as Figure 5. Underneath the lamps 4 in Figure 1, the light irradiation chamber 1 is formed which is shown in Figure 5. Thus, Figure 1 only illustrates the light irradiation part for clarity and not the complete heating device which is similar to that shown in Figure 5 other than the light irradiation part.

The lamp 4 is an annular filament lamp with an emitting tube portion 7 to which an insertion portion 8 is vertically arranged, with ends provided with sealing areas 11 to which an electrical line is connected. The mirror 5 is provided with openings 6 through which the sealing areas 11 and the insertion portions 8 of the lamps 4 pass. Thus, the lamps 4 are attached in the mirror 5. The lamp side of the mirror 5 (i.e. the side adjacent to the lamp 4) is a mirror surface and is provided with grooves (not shown in Figure 1) which are matched to the annular shape of the lamps 4. Figure 1 shows only two lamps. In practice, however, a dozen or so up to a few dozen lamps may be used according to the size of the wafer to be treated.

The duct 30 is formed somewhat like a toroidal as was described above, and has a hollow area 30a. The mirror 5 is installed underneath the duct 30. At two points of the duct 30, there is one cooling air inlet opening 30b each, through which cooling air is let in. In the area of the duct 30 in which the mirror 5 is installed, there are several cooling air exhaust openings 30c. Furthermore, in the mirror 5, there are through cooling air exhaust openings 5a which correspond to the above described cooling air exhaust openings 30c of the duct 30. The cooling air which cools the lamps 4 and the like is supplied by the duct 30 via the above described exhaust openings 30c and exhaust openings 5a of the light irradiation chamber. Above the duct 30, the plate 10 is installed which closes the inside of the duct 30 except for the cooling air inlet openings 30b and the cooling air exhaust openings 30c. The sealing areas 11 of the lamps 4 pass through the openings 16 of the plate 10.

As was described above, on the plate 10, there are terminal devices and a line system which supply electricity to the lamps 4, and components which hold and attach the sealing areas 11 of the lamps. The plate 10 is covered by a cover (not shown in Figure 1) that forms a cover chamber in the manner shown and described relative to Figure 5. The bottom of the hollow area 30a of the duct 30 is closed by the rear surface of the mirror 5 (i.e. the side adjacent the duct 30) and the top of the hollow area 30a is closed by the bottom of the plate 10. In this way, a closed space is formed. However, there is a gap 30d provided to which the outlet channel 20 is connected at one portion of the hollow area 30a which is located between the two cooling air inlet openings 30b.

The flow of cooling air through the light irradiation part shown in Figure 1 is described herein below. The cooling air is admitted through the cooling air inlet openings 30b at two points of the duct 30 into the inside of the duct 30. The cooling air in the duct 30 is exhausted through several cooling air exhaust openings 30c to the cooling air exhaust openings 5a of the mirror 5 and into the light irradiation chamber which is on the flat side of the mirror adjacent to the lamps 4. The exhausted cooling air cools the insertion portions 8 of the lamps 4, flows along the grooves located on the mirror surface, and through the openings 6 of the mirror 5 through which the insertion portions 8 of the lamps and the sealing areas 11 pass, the insertion portions 8 being admitted into the hollow area 30a which has a top surrounded by the plate 10 and a bottom which is surrounded by the back of the mirror 5. The cooling air admitted into the hollow area 30a with a high temperature is evacuated by the gap 30d of the hollow area 30a via the outlet channel 20 through an evacuation opening 20a from the device to the outside. An exhauster (not shown in Figure 1) similar to that shown in Figure 5 is connected via a channel to the evacuation opening 20a.

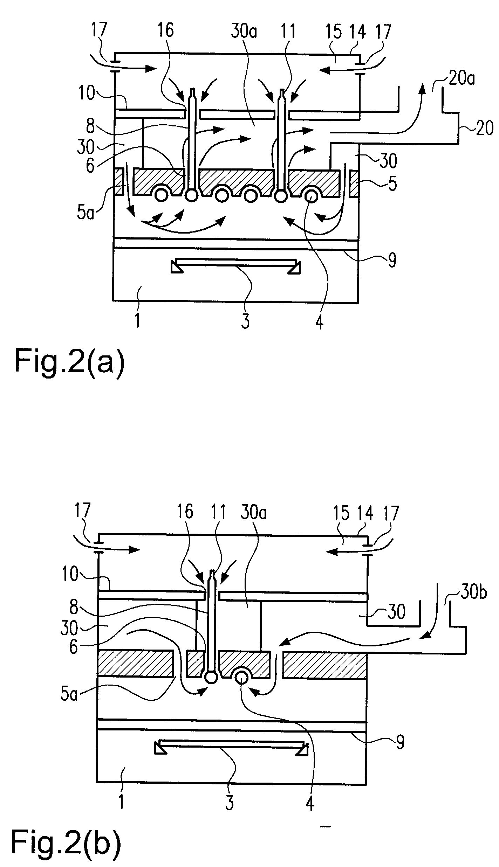

Figures 2(a) and 2(b) show the flow of cooling air in the above described arrangement of the light irradiation part shown in Figure 1. Figure 2 (a) is a cross section along A-A shown in Figure 1. Figure 2 (b) is a cross section along B-B shown in Figure 1. Figures 2 (a) and (b) show a quartz window 9 and a wafer 3 underneath the mirror 5, and a cover 14, a cover chamber 15 and the like above the plate 10 which were not shown in Figure 1. However, the holding component 18, the line 19, the terminal device 23 and the like which are shown in Figure 5, are not shown in Figures 2(a) and 2(b). Figure 2(a) shows mainly the passage for evacuation of the cooling air in the cross section, while Figure 2(b) shows mainly the inlet passage for the cooling air in the cross section.

First, blowing of the admitted cooling air out into the light irradiation chamber 1 and the evacuation of the cooling air are described using Figure 2(a). In Figure 2(a), the cooling air admitted into the duct 30 passes through the cooling air exhaust opening 30c (see Figure 1) located in the bottom of the duct 30, and passes through the cooling air exhaust openings 5a located in the mirror 5. The cooling air is blown out onto the side of the light irradiation chamber 1, cools the emitting tube portions 7 of the lamps 4, passes through the openings 6 of the mirror 5, and is admitted into the hollow area 30a. The hollow area 30a of the duct 30 is provided with a gap 30d as is shown in Figure 1. A ventilation passage for evacuation is formed by the closing of the bottom side of the hollow area 30a by the back of the mirror 5 and the top side by the plate 10. The cooling air which has been admitted into the hollow area 30a with a high temperature is evacuated via this ventilation path for evacuation through the evacuation opening 20a of the outlet channel 20.

The cooling air which cools the sealing areas 11 of the lamps 4 is, as in Figure 5, admitted through the cooling air inlet opening 17 of the cover 14 which is located above the plate 10, and is pulled into the hollow area 30a through the openings 16 of the plate 10 through which the sealing areas pass. In the case in which the plate 10 is a water cooling plate, the above described cooling air inlet opening 17 need not be located in the cover 14.

The supply of cooling air into the light irradiation chamber 1 is described below using Figure 2(b). In Figure 2(b), the cooling air is admitted through the cooling air inlet openings 30b into the duct 30. The cooling air admitted into the duct 30 is blown out through the cooling air exhaust openings 30c and 5a onto the side of the light irradiation chamber 1 and also cools the lamps 4. The cooling air which cools the lamps 4 is, as was described using Figure 2 (a), admitted into the hollow area 30a, and evacuated through the evacuation opening 20a of the outlet channel 20.

As was described above, the hollow area 30a in which the cooling air with a high temperature flows after cooling of the lamps 4, is surrounded by the duct 30 into which cooling air with a low temperature is also admitted. The top of the hollow area 30a over the plate 10 is provided with a cover chamber 15 which has a temperature essentially the same as room temperature. The bottom of the hollow area 30a is provided with a mirror 5 which may be subjected to water cooling. Therefore, the area with a high temperature can be made smaller on the outside periphery of the device. On the surface of the device, only the area of the outlet channel 20 reaches a high temperature. However, because only this part reaches a high temperature, the device is not as large as in a typical case even with the cover in place. Thus, an increase in costs can be avoided.

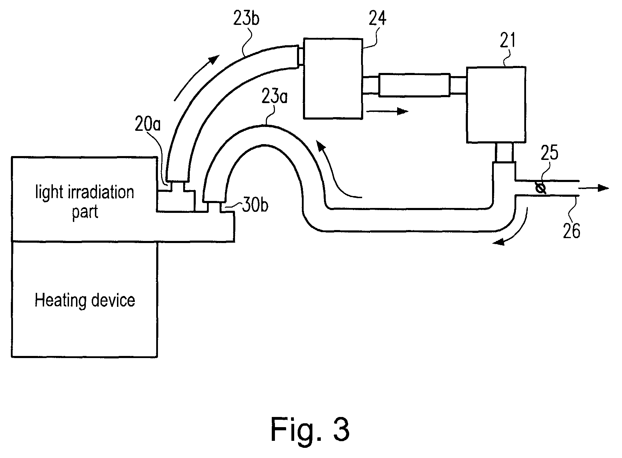

Figure 3 is a schematic of the installation of a system with circulating air into the above described light irradiation part in which the cooling air evacuated from the device is re-used as cooling air. In Figure 3, the cooling air inlet opening 30b of the duct 30 is provided with a channel 23a and the evacuation opening 20a is provided with a channel 23b. The cooling air with a high temperature after cooling the lamp is evacuated to the outside by the exhauster 21 through the evacuation opening 20a from the light irradiation device. The cooling air with a high temperature which has been evacuated through the evacuation opening 20a is admitted via the channel 23b into a heat exchanger 24 where it is cooled, for instance, to room temperature, and admitted into the exhauster 21. The cooling air evacuated from the exhauster 21 is admitted via the channel 23a to the cooling air inlet opening 30b and is re-used as cooling air.

The cooling air admitted into the system with circulating cooling in the above described manner from the cooling air inlet opening 17 of the cover chamber 15 for cooling of the sealing areas 11 is accordingly subjected to forced evacuation via a damper 25 through the evacuation opening 26 which is located on the side of the outlet of the exhauster 21, by which the amount of cooling air and the air pressure are controlled. Clean air is used for cooling of the sealing areas 11. However, since only a small amount of air is needed, evacuation does not lead to a major increase in costs.

Furthermore, for the above described plate 10, a water cooling plate can be used in which a water cooling tube is embedded therein. The water cooling plate makes it possible to reduce the temperature of the plate with which the cooling air with a high temperature is in contact as well as the temperature of the exterior surface of the device. Moreover, in such a case where a water cooling plate is used as the plate 10, clean air need not always be admitted through the cooling air inlet opening 17a of the cover chamber 15.

However, if the plate 10 used is not water-cooled, the temperature of the plate 10 becomes high due to the cooling air with a high temperature having been pulled into the hollow area 30a. In order to reduce the size of the area with a high temperature which projects over the surface of the heating device, the cover 14 is provided. Since cooling air for cooling the sealing areas 11 is pulled into the cover 14 as was described above, low surface temperature of the cover 14 is maintained.

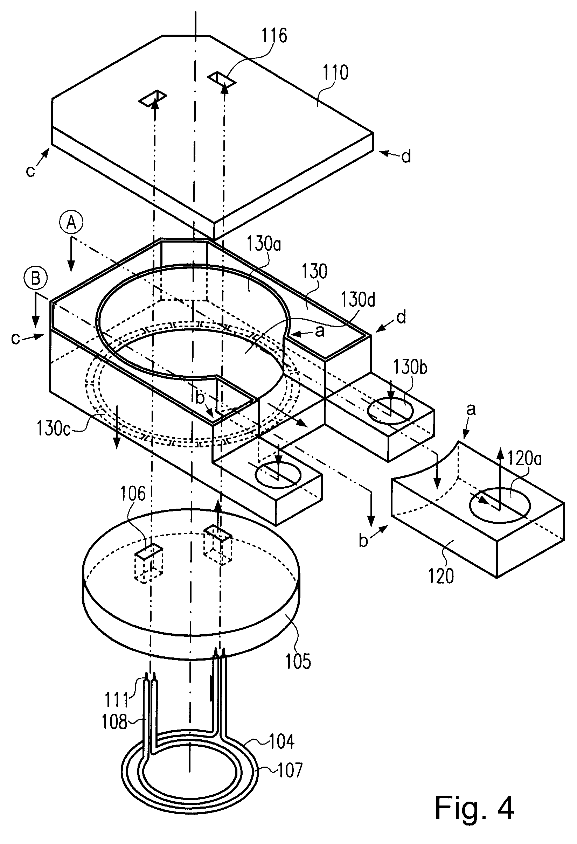

Figure 4 shows another embodiment similar to that shown in Figure 1. In the figure, the same parts as in Figure 1 are provided with the same reference numbers as in Figure 1 except that the numbers are above one hundred. The difference from Figure 1 is that the mirror 105 is disk-shaped and fits into the hollow area 130a of the duct 130. Therefore, mirror 105 is not provided with a cooling air exhaust opening 5a as shown in the embodiment of Figure 1. The cooling air from the duct 130 is blown out through the cooling air exhaust opening 130c located on the bottom of the duct 130, and onto the side of the light irradiation chamber 101. The remaining arrangement, the admission and the evacuation of the cooling air, are substantially identical to those of Figure 1 and thus, further discussion is omitted to avoid repetition. As in Figure 1, besides the area of the outlet channel 120, the temperature of the surface of the device can be kept low.

Therefore, the present invention provides an arrangement of the light irradiation part of a heating device of the light irradiation type where the duct into which the cooling air is let in is arranged such that the air box into which the cooling air with a high temperature flows after lamp cooling, is enclosed. Therefore, in the outside periphery of the device, the area with a high temperature can be made smaller. Consequently, the safety of the device can be increased and the device can be prevented from becoming larger and costs prevented from increasing. Since the cooling air is admitted through the cooling air inlet openings, and is evacuated through the evacuation opening, a system with circulating cooling can be easily built. Therefore, the lamps can be cooled without consuming a large amount of clean air. Thus production costs can be reduced.

While various embodiments in accordance with the present invention have been shown and described, it is understood that the invention is not limited thereto. The present invention may be changed, modified and further applied by those skilled in the art. Therefore, this invention is not limited to the detail shown and described previously, but also includes all such changes and modifications.

## Claims

1. Light irradiation part arrangement of a heating device of the light irradiation type having plurality of lamps in a light irradiation chamber, each of the plurality of lamps having an emitting tube portion, at least one insertion portion which extends away from the emitting tube portion, the at least one insert portion having a sealing area, the light irradiation part arrangement comprising:
a mirror behind the emitting tube portions of the lamps which reflects the light from the emitting tube portions, the mirror having at least one opening through which the insertion portion and the sealing area of the insertion portion are routed;
a plate located above the mirror, the plate having at least one opening through which the sealing area of the insertion portion is routed; and
a duct located between the mirror and the plate adapted to supply cooling air to the plurality of lamps, the duct defining a hollow area between the mirror and the plate that is positioned to allow routing of the at least one insertion portion, one side of the hollow area being covered by the mirror and on the opposite side of the hollow area being covered by the plate;
wherein the duct is connected to at least one cooling air inlet opening that lets in cooling air, and has at least one cooling air exhaust opening that blows cooling air out of the duct toward the light irradiation chamber.

2. Light irradiation part arrangement as claimed in claim 1, wherein the at least one opening in the mirror has a larger diameter than the outside diameter of the at least one insertion portion of each of the plurality of lamps so that cooling air from the light irradiation chamber flows through the at least one opening into the hollow area defined by the duct.

3. Light irradiation part arrangement as claimed in claim 2, wherein the hollow area defined by the duct is connected to at least one outlet channel.

4. Light irradiation part arrangement as claimed in claim 3, wherein the at least one outlet channel is connected to an evacuation opening.

5. Light irradiation part arrangement as claimed in claim 4, wherein the evacuation opening is connected to at least one exhaust channel connected to an evacuation device.

6. Light irradiation part arrangement as claimed in any one of claims 2 to 5, wherein the duct substantially surrounds the hollow area.

7. Light irradiation part arrangement as claimed in any one of claims 1 to 6, wherein the mirror has an opening that aligns with the at least one cooling air exhaust opening of the duct to allow cooling air to flow out of the duct channel into the light irradiation chamber.

8. Light irradiation part arrangement as claimed in claim 1, wherein the mirror is dimensioned to extend only over the hollow area defined by the duct.

9. Light irradiation part arrangement as claimed in any one of claims 1 to 8, wherein the at least one cooling air inlet opening is connected to a circulating cooling system with a heat exchange medium that cools evacuated cooling air from the heating device and supplies the cooled air to at least one cooling air inlet opening.
